(19) Europäisches Patentamt
European Patent Office
Office européen des brevets

(11) EP 3 901 323 A1

(12) EUROPEAN PATENT APPLICATION
published in accordance with Art. 153(4) EPC

(43) Date of publication:
27.10.2021 Bulletin 2021/43

(51) Int Cl.:
C23C 14/54 (2006.01)    C23C 14/26 (2006.01)
C23C 14/24 (2006.01)    H05B 6/06 (2006.01)
G01R 27/26 (2006.01)

(21) Application number: 19899082.2

(22) Date of filing: 10.12.2019

(86) International application number:
PCT/KR2019/017361

(87) International publication number:
WO 2020/130458 (25.06.2020 Gazette 2020/26)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 19.12.2018 KR 20180165450

(71) Applicant: POSCO
Pohang-si, Gyeongsangbuk-do 37859 (KR)

(72) Inventors:
• JUNG, Yong-Hwa
Gwangyang-si, Jeollanam-do 57807 (KR)
• NAM, Kyung-Hoon
Gwangyang-si, Jeollanam-do 57807 (KR)
• KIM, Tae-Yeob
Gwangyang-si, Jeollanam-do 57807 (KR)
• JUNG, Woo-Sung
Gwangyang-si, Jeollanam-do 57807 (KR)
• KO, Kyoung-Pil
Gwangyang-si, Jeollanam-do 57807 (KR)

(74) Representative: Zech, Stefan Markus
Meissner Bolte Patentanwälte
Rechtsanwälte Partnerschaft mbB
Postfach 86 06 24
81633 München (DE)

(54) **APPARATUS AND METHOD FOR CONTROLLING COATING LAYER IN PVD PLATING PROCESSS**

(57)    The present invention provides an apparatus for controlling a coating layer in a physical vapor deposition (PVD) plating process that forms a coating layer on a steel sheet with metal vapor by means of PVD. The apparatus for controlling a coating layer comprises : a crucible into which a molten material is introduced; an electromagnetic induction coil disposed around the outer periphery of the crucible to heat the molten material introduced into the crucible and form a molten metal to generate metal vapor from the molten metal; a power supply unit for supplying an electric current to the electromagnetic induction coil; and a control unit for measuring the impedance of the electromagnetic induction coil and controlling the electric current supplied to the electromagnetic induction coil so that the impedance is kept constant according to the molten material which is introduced into the crucible at a constant feed rate.

【Fig.1】

**Description**

[Technical Field]

The present disclosure relates to an apparatus and a method for controlling a coating layer in physical vapor deposition (PVD) process, and more particularly, to an apparatus and a method for controlling an evaporation amount of a molten metal to control a thickness of a coating layer in a PVD plating process in which a steel sheet is coated using PVD.

[Background Art]

In a PVD plating process of coating a substrate moving in vacuum with metal vapor, a coating medium may be melted or heated by directing heating a crucible to generate a large amount of metal vapor (see European Patent Publication No. 1, 785, 010, for example), or a conductive medium may be heated by electromagnetic induction in a non-contact manner to generate metal vapor (see Korean Patent Publication No. 10-2007-0067097, for example). The two documents disclose a basic concept of PVD in which coating vapor is generated in vacuum to coat a substrate, but fail to disclose a technology to control a coating weight. That is, development of a unique coating weight control technology for PVD is required to manufacture plated products.

For coating a surface of a moving strip with metal vapor, hot-dip galvanizing and electroplating are mainly used in the related art. In the related art, a method of controlling a gap and a pressure of air knives (in the case of hot-dip galvanizing) or a method of controlling multiplication of current by time (in the case of electroplating) has been applied to control a coating weight. The above-mentioned technologies manufacture plated products in a manner of directly controlling a coating weight.

The inventor of the present disclosure developed a PVD plating apparatus for applying the above-mentioned PVD plating process to coating of a moving strip. A technology, capable of controlling a coating weight, is necessarily required to commercialize the PVD plating apparatus.

[Disclosure]

[Technical Problem]

An aspect of the present disclosure is to provide an apparatus and a method for controlling an amount of metal vapor, generated in a PVD plating process, to control a coating layer of a steel sheet.

[Technical Solution]

According to an aspect of the present disclosure, an apparatus for controlling a coating layer in a physical vapor deposition (PVD) plating process, in which a steel sheet is subjected to PVD with metal vapor to form a coating layer, is provided. The apparatus includes: a crucible into which a molten material is introduced; an electromagnetic induction coil disposed around an external periphery of the crucible to heat the molten material introduced to the crucible and to form a molten metal to generate metal vapor from the molten metal; a power supply unit configured to supply current to the electromagnetic induction coil; and a control unit configured to measure impedance of the electromagnetic induction coil and to control the current, supplied to the electromagnetic induction coil, such that the impedance is maintained to be constant, depending on the molten material introduced to the crucible.

In an example embodiment, the control unit may measure a resonant frequency of the electromagnetic induction coil to obtain the impedance of the electromagnetic induction coil.

In an example embodiment, the control unit may control the current, supplied to the electromagnetic induction coil, such that a heating value generated by the electromagnetic induction coil is set to be constant.

In an example embodiment, the heating value may correspond to an amount of power of the electromagnetic induction coil, and the control unit may control the current, supplied to the electromagnetic induction coil, such that the amount of the power of the electromagnetic induction coil is set to be constant.

According to another aspect of the present disclosure, a method for controlling a coating layer in a physical vapor deposition (PVD) plating process, in which a steel sheet is subjected to PVD with metal vapor to form a coating layer, is provided. The method includes: introducing a molten material into a crucible; heating the molten material, introduced to the crucible, with an electromagnetic induction coil, disposed around an external periphery of the crucible, and forming a molten material to generate metal vapor; measuring impedance of the electromagnetic induction coil; and controlling current, supplied to the electromagnetic induction coil, such that the impedance of the electromagnetic induction coil is maintained to be constant, depending on the molten material introduced to the crucible at a constant feed rate.

In an example embodiment, the measuring of impedance of the electromagnetic induction coil may include measuring a resonant frequency of the electromagnetic induction coil to obtain the impedance of the electromagnetic induction coil.

In an example embodiment, the controlling of the current supplied to the electromagnetic induction coil may include controlling the current, supplied to the electromagnetic induction coil, such that a heating value generated by the electromagnetic induction coil is set to be constant.

In an example embodiment, the heating value corresponds to an amount of power of the electromagnetic induction coil, and the controlling of the current supplied to the electromagnetic induction coil may include controlling the current, supplied to the electromagnetic induction coil, such that the amount of the power of the electromagnetic induction coil is set to be constant.

The technical solution clause does not necessarily describe all necessary features of the present disclosure. The present disclosure may also be a sub-combination of the features described above.

[Advantageous Effects]

As set forth above, the amount of metal vapor, generated in a PVD plating process, may be controlled to be constant. Thus, a coating layer formed on a steel sheet may be controlled to be constant.

[Description of Drawings]

FIG. 1 is a schematic diagram of an apparatus for controlling a coating layer in a PVD plating process according to an example embodiment of the present disclosure.
FIG. 2 is a schematic flowchart illustrating a method for controlling a coating layer in a PVD plating process according to an example embodiment of the present disclosure.

[Best Mode for Invention]

Hereinafter, an apparatus and a method for controlling a coating layer in a PVD plating process according to example embodiments of the present disclosure will be described with reference to accompanying drawings.

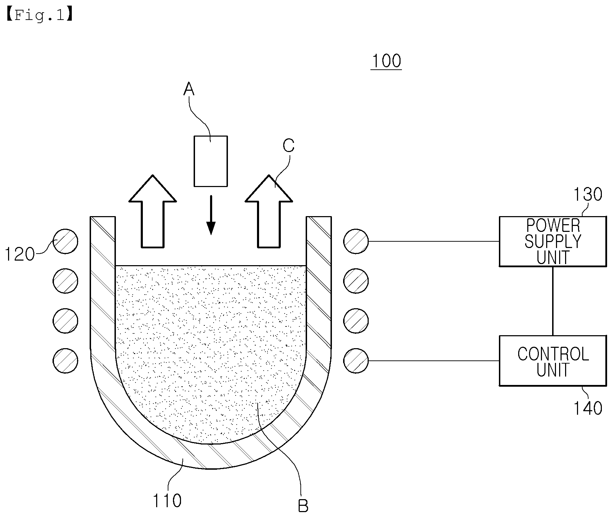

FIG. 1 is a block diagram of an apparatus 100 for controlling a coating layer in a PVD plating process according to an example embodiment of the present disclosure. As illustrated in FIG. 1, the apparatus 100 may be used in a PVD plating process in which a strip is subjected to physical vapor deposition (PVD) with metal vapor to form a coating layer. The apparatus 100 may include a crucible 110 into which a molten material 'A' is introduced, an electromagnetic induction coil 120 disposed around an external periphery of the crucible 110 to heat the molten material 'A' introduced to the crucible 110 and to form a molten metal 'B' to generate metal vapor 'C' from the molten metal 'B,' a power supply unit 130 supplying current to the electromagnetic induction coil 120, and a control unit 140 controlling the current supplied to the electromagnetic induction coil 120.

In the PVD plating process, a plating medium of a predetermined component (for example, the molten material 'A') may be introduced to the crucible 110 in which the electromagnetic induction coil 120 is disposed around the external periphery, and current may be supplied to the electromagnetic induction coil 120 to form the molten metal 'B' in the crucible 110. Thus, the metal vapor 'C' may be generated, and then deposited on the strip to form a coating layer. For this reason, the coating layer may be controlled by controlling the amount of the metal vapor 'C.'

The present disclosure proposes a method of controlling a coating layer. According to the method, the same amount of molten material 'A' as the metal vapor 'C' to be generated may be introduced to the crucible 110 to control the amount of the metal vapor 'C' and then the amount of the molten metal 'B,' for example, the volume of the molten metal 'B' may be maintained to be constant, so that the coating layer may be controlled.

To this end, the control unit 140 may measure impedance of the electromagnetic induction coil 120 and may control the current, supplied to the electromagnetic induction coil 120, such that the impedance may be maintained to be constant. For example, the control unit 140 may control parameters of the current, supplied to the electromagnetic induction coil 120, including the magnitude of the current, or the like. The impedance of the electromagnetic induction coil 120 may vary depending on a change in volume of the molten metal 'B' in the crucible 110. Accordingly, when the current supplied to the electromagnetic induction coil 120, for example, the magnitude of the current, or the like, is controlled such that the impedance of the electromagnetic induction coil 120 is set to be constant depending on the molten material 'A' introduced to the crucible 110 at a constant feed rate, the volume of the molten metal 'B' may be controlled to be constant. Results of simulation for the amount of the molten metal 'B' and the impedance of the electromagnetic induction coil 120 are listed in Table 1 below.

Table 1

| Amount of Molten Steel(kg) | 1 | 1.5 | 2 | 2.5 | 3 | 3.5 |
|---|---|---|---|---|---|---|
| Impedance | 4.7 | 4.35 | 4.18 | 4.12 | 4.06 | 4 |

Accordingly, it is confirmed that the larger the volume of the molten metal 'B,' the lower the impedance of the electromagnetic induction coil 120. The control unit 140 may measure a resonant frequency of the electromagnetic induction coil 120 to obtain the impedance of the electromagnetic induction coil 120. A relationship between the resonant frequency and the impedance of the electromagnetic induction coil is represented by the following equation 1.

Equation 1:

$$f = \frac{1}{2\pi\sqrt{LC}}$$

where f is the resonant frequency of the electromagnetic induction coil 120, L is the impedance of the electromagnetic induction coil 120, and C is capacitance in a PVD plating apparatus and is a fixed value.

Accordingly, the coating layer may be controlled by measuring the resonant frequency and controlling power, supplied to the electromagnetic induction coil 120, such that the resonant frequency is set to be constant.

The feed rate of the molten material 'A' fed into the crucible 110 and a generation rate of the metal vapor 'C' should match each other. For example, the amount of the molten material 'A' fed per unit time and the amount of the metal vapor 'C' generated per unit time should match each other. To this end, the metal vapor 'C' may be maintained to be constant, depending on the introduced molten material 'A' by maintaining a heating value of the electromagnetic induction coil 120 to be constant depending on the molten material 'A' introduced to the crucible 110 at the constant feed rate, in addition to by maintaining the volume of the molten metal 'B' to be constant depending on the molten material 'A' introduced to the crucible 110 at the constant feed rate.

The heating value may correspond to energy required for maintenance of the temperature of the molten metal 'B,' an increase in the temperature of the fed molten material 'A,' and evaporation heat. The heating value may correspond to the amount of power of the electromagnetic induction coil 120, and the controller 140 may control the current supplied to the electromagnetic induction coil 120 such that the amount of power of the electromagnetic induction coil 120 is set to be constant.

As described above, in the apparatus for controlling a coating layer in the PVD plating process according to an example embodiment, impedance (for example, a resonant frequency) and a heating value (for example, the amount of power) may be controlled to be constant to correspond to a molten material fed at a constant feed rate, so that a heating value of metal vapor may be controlled to be constant. As a result, a constant coating layer may be formed.

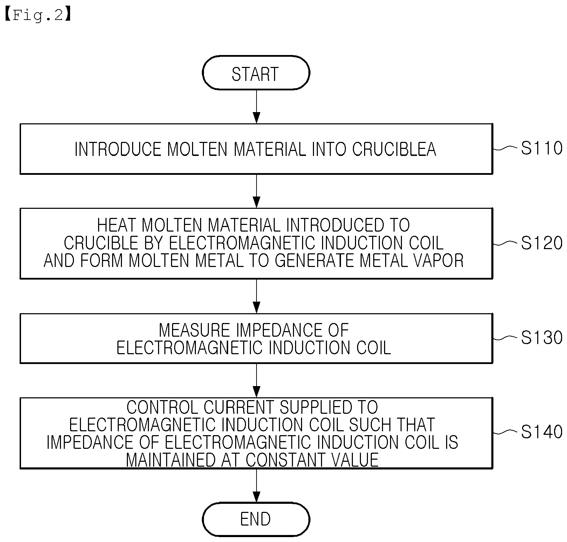

Next, a method for controlling a coating layer in a PVD plating process according to an example embodiment of the present disclosure will be described with reference to FIG. 2. FIG. 2 is a schematic flowchart illustrating a method 200 for controlling a coating layer in a PVD plating process according to an example embodiment. The method 200 for controlling a coating layer according to an example embodiment may be used in a PVD plating process in which a strip is subjected to physical vapor deposition with metal vapor to form a coating layer.

The method 200 may start with operation S210 in which a molten material is introduced to a crucible. In operation S220, the molten material in the crucible may be heated with an electromagnetic induction coil disposed around an external periphery of the crucible, and then a molten metal may be formed to generate metal vapor. In operation S230, impedance of the electromagnetic induction coil may be measured. In operation S240, current supplied to the electromagnetic induction coil may be controlled such that the impedance of the electromagnetic induction coil is maintained to be constant according to the molten material introduced to the crucible at a constant feed rate. A procedure and a principle of each operation of the method 200 are substantially the same as those of each component of the above-described apparatus 100, and thus, detailed descriptions thereof will be omitted.

In operation S230 in which the impedance of the electromagnetic induction coil is measured, a resonant frequency of the electromagnetic induction coil may be measured to obtain the impedance of the electromagnetic induction coil. As described above, the impedance may be calculated from the resonant frequency (for example, using Equation 1). Therefore, when the current of the electromagnetic induction coil is controlled such that the resonant frequency is set to be constant, the impedance may be set to be constant.

In an example embodiment, in operation S240 in which the current supplied to the electromagnetic induction coil is controlled, the current supplied to the electromagnetic induction coil may be controlled such that a heating value generated by the electromagnetic induction coil is set to be constant, in addition to controlling the current supplied to the electromagnetic induction coil such that the impedance of the electromagnetic induction coil is maintained to be constant, depending on the molten material introduced to the crucible at a constant feed rate.

In this case, the heating value may correspond to the amount of power of the electromagnetic induction coil. Accordingly, in operation S240 in which the current supplied to the electromagnetic induction coil is controlled, the current supplied to the electromagnetic induction coil may be controlled such that the amount of power of the electromagnetic induction coil is set to be constant, and thus, the heating value may be set to be constant.

As described above, in the method for controlling a coating layer in a PVD plating process according to an example embodiment, similarly to the above-described method for controlling a plating layer, impedance (for example, a resonant frequency) and a heating value (for example, the amount of power) may be controlled to be constant to correspond to a molten material fed at a constant feed rate, so that a heating value of metal vapor may be controlled to be constant. As a result, a constant coating layer may be formed.

While examples embodiments in the present disclosure have been described in detail, however, claims of the present disclosure are not limited thereto, and it will be apparent to those skilled in the art that various modifications and changes may be made without departing from the technological concepts of the present disclosure described in the claims.

[DESCRIPTION OF REFERENCE NUMERALS]

100    APPARATUS FOR CONTROLLING COATING LAYER
110    CRUCIBLE
120    ELECTROMAGNETIC INDUCTION COIL
130    POWER SUPPLY UNIT
140    CONTROL UNIT
A    MOLTEN MATERIAL
B    MOLTEN STEEL
C    METAL VAPOR

**Claims**

1.    An apparatus for controlling a coating layer in a physical vapor deposition (PVD) plating process in which a steel sheet is subjected to PVD with metal vapor to form a coating layer, the apparatus comprising:

a crucible into which a molten material is introduced;
an electromagnetic induction coil disposed around an external periphery of the crucible to heat the molten material introduced to the crucible and to form a molten metal to generate metal vapor from the molten metal;
a power supply unit configured to supply current to the electromagnetic induction coil; and
a control unit configured to measure impedance of the electromagnetic induction coil and to control the current, supplied to the electromagnetic induction coil, such that the impedance is maintained to be constant, depending on the molten material introduced to the crucible.

2.    The apparatus of claim 1, wherein the control unit measures a resonant frequency of the electromagnetic induction coil to obtain the impedance of the electromagnetic induction coil.

3.    The apparatus of claim 1, wherein the control unit controls the current, supplied to the electromagnetic induction coil, such that a heating value generated by the electromagnetic induction coil is set to be constant.

4.    The apparatus of claim 3, wherein the heating value corresponds to an amount of power of the electromagnetic induction coil, and the control unit controls the current, supplied to the electromagnetic induction coil, such that the amount of the power of the electromagnetic induction coil is set to be constant.

5.    A method for controlling a coating layer in a physical vapor deposition (PVD) plating process in which a steel sheet is subjected to PVD with metal vapor to form a coating layer, the method comprising:

introducing a molten material into a crucible;

heating the molten material, introduced to the crucible, with an electromagnetic induction coil, disposed around an external periphery of the crucible, and forming a molten material to generate metal vapor;

measuring impedance of the electromagnetic induction coil; and

controlling current, supplied to the electromagnetic induction coil, such that the impedance of the electromagnetic induction coil is maintained to be constant, depending on the molten material introduced to the crucible at a constant feed rate.

6. The method of claim 5, wherein the measuring of impedance of the electromagnetic induction coil includes measuring a resonant frequency of the electromagnetic induction coil to obtain the impedance of the electromagnetic induction coil.

7. The method of claim 5, wherein the controlling of the current supplied to the electromagnetic induction coil includes controlling the current, supplied to the electromagnetic induction coil, such that a heating value generated by the electromagnetic induction coil is set to be constant.

8. The method of claim 7, wherein the heating value corresponds to an amount of power of the electromagnetic induction coil, and

wherein the controlling of the current supplied to the electromagnetic induction coil includes controlling the current, supplied to the electromagnetic induction coil, such that the amount of the power of the electromagnetic induction coil is set to be constant.

【Fig.1】

100

A

C

130

POWER
SUPPLY
UNIT

120

CONTROL
UNIT

140

110

B

【Fig.2】

```
                    ┌─────────────┐
                    │    START    │
                    └──────┬──────┘
                           ▼
┌──────────────────────────────────────────────┐
│   INTRODUCE MOLTEN MATERIAL INTO CRUCIBLEA     │── S110
└──────────────────────┬───────────────────────┘
                       ▼
┌──────────────────────────────────────────────┐
│        HEAT MOLTEN MATERIAL INTRODUCED TO      │
│   CRUCIBLE BY ELECTROMAGNETIC INDUCTION COIL   │── S120
│   AND FORM MOLTEN METAL TO GENERATE METAL VAPOR│
└──────────────────────┬───────────────────────┘
                       ▼
┌──────────────────────────────────────────────┐
│            MEASURE IMPEDANCE OF                 │
│      ELECTROMAGNETIC INDUCTION COIL             │── S130
└──────────────────────┬───────────────────────┘
                       ▼
┌──────────────────────────────────────────────┐
│         CONTROL CURRENT SUPPLIED TO            │
│   ELECTROMAGNETIC INDUCTION COIL SUCH THAT     │── S140
│ IMPEDANCE OF ELECTROMAGNETIC INDUCTION COIL IS │
│        MAINTAINED AT CONSTANT VALUE            │
└──────────────────────┬───────────────────────┘
                       ▼
                ┌─────────────┐
                │     END     │
                └─────────────┘
```

## INTERNATIONAL SEARCH REPORT

| | International application No. |
|---|---|
| | PCT/KR2019/017361 |

**A. CLASSIFICATION OF SUBJECT MATTER**

*C23C 14/54(2006.01)i, C23C 14/26(2006.01)i, C23C 14/24(2006.01)i, H05B 6/06(2006.01)i, G01R 27/26(2006.01)i*

According to International Patent Classification (IPC) or to both national classification and IPC

**B. FIELDS SEARCHED**

Minimum documentation searched (classification system followed by classification symbols)

C23C 14/54; C21C 1/08; C21C 5/52; C23C 14/24; F27B 14/06; F27B 3/28; G01F 23/00; G01F 23/26; C23C 14/26; H05B 6/06; G01R 27/26

Documentation searched other than minimum documentation to the extent that such documents are included in the fields searched
Korean utility models and applications for utility models: IPC as above
Japanese utility models and applications for utility models: IPC as above

Electronic data base consulted during the international search (name of data base and, where practicable, search terms used)
eKOMPASS (KIPO internal) & Keywords: coil, crucible, impedance, deposition

**C. DOCUMENTS CONSIDERED TO BE RELEVANT**

| Category* | Citation of document, with indication, where appropriate, of the relevant passages | Relevant to claim No. |
|---|---|---|
| Y | KR 10-2011-0078959 A (SNU PRECISION CO., LTD.) 07 July 2011<br>See claims 1, 19, 22 and figure 1. | 1-8 |
| Y | KR 10-2010-0071350 A (RESEARCH INSTITUTE OF INDUSTRIAL SCIENCE & TECHNOLOGY) 29 June 2010<br>See claim 1. | 1-8 |
| A | KR 10-2013-0066723 A (POSCO et al.) 21 June 2013<br>See claim 1. | 1-8 |
| A | JP 2914674 B2 (HITACHI, LTD.) 05 July 1999<br>See claims 1, 4. | 1-8 |
| A | EP 0384987 A1 (HITACHI, LTD.) 05 September 1990<br>See claims 1, 14. | 1-8 |

☐ Further documents are listed in the continuation of Box C.    ☒ See patent family annex.

| *   Special categories of cited documents: | "T"   later document published after the international filing date or priority date and not in conflict with the application but cited to understand the principle or theory underlying the invention |
|---|---|
| "A"   document defining the general state of the art which is not considered to be of particular relevance | |
| "E"   earlier application or patent but published on or after the international filing date | "X"   document of particular relevance; the claimed invention cannot be considered novel or cannot be considered to involve an inventive step when the document is taken alone |
| "L"   document which may throw doubts on priority claim(s) or which is cited to establish the publication date of another citation or other special reason (as specified) | "Y"   document of particular relevance; the claimed invention cannot be considered to involve an inventive step when the document is combined with one or more other such documents, such combination being obvious to a person skilled in the art |
| "O"   document referring to an oral disclosure, use, exhibition or other means | |
| "P"   document published prior to the international filing date but later than the priority date claimed | "&"   document member of the same patent family |

| Date of the actual completion of the international search | Date of mailing of the international search report |
|---|---|
| 23 MARCH 2020 (23.03.2020) | **26 MARCH 2020 (26.03.2020)** |

| Name and mailing address of the ISA/KR | Authorized officer |
|---|---|
| Korean Intellectual Property Office<br>Government Complex Daejeon Building 4, 189, Cheongsa-ro, Seo-gu, Daejeon, 35208, Republic of Korea<br>Facsimile No. +82-42-481-8578 | Telephone No. |

Form PCT/ISA/210 (second sheet) (January 2015)

9

INTERNATIONAL SEARCH REPORT
Information on patent family members

International application No.

**PCT/KR2019/017361**

| Patent document cited in search report | Publication date | Patent family member | Publication date |
|---|---|---|---|
| KR 10-2011-0078959 A | 07/07/2011 | CN 102712994 A | 03/10/2012 |
| | | CN 102712994 B | 20/08/2014 |
| | | EP 2519656 A2 | 07/11/2012 |
| | | EP 2519656 A4 | 20/08/2014 |
| | | EP 2519656 B1 | 04/10/2017 |
| | | JP 2013-515862 A | 09/05/2013 |
| | | JP 5695669 B2 | 08/04/2015 |
| | | KR 10-1172275 B1 | 08/08/2012 |
| | | TW 201131101 A | 16/09/2011 |
| | | TW I440792 B | 11/06/2014 |
| | | US 2013-0011804 A1 | 10/01/2013 |
| | | WO 2011-081368 A2 | 07/07/2011 |
| | | WO 2011-081368 A3 | 27/10/2011 |
| KR 10-2010-0071350 A | 29/06/2010 | None | |
| KR 10-2013-0066723 A | 21/06/2013 | None | |
| JP 2914674 B2 | 05/07/1999 | DE 68913953 T2 | 07/07/1994 |
| | | EP 0384987 A1 | 05/09/1990 |
| | | EP 0384987 B1 | 16/03/1994 |
| | | JP 02-225630 A | 07/09/1990 |
| | | KR 10-1992-0007882 B1 | 18/09/1992 |
| | | US 4996402 A | 26/02/1991 |
| EP 0384987 A1 | 05/09/1990 | DE 68913953 T2 | 07/07/1994 |
| | | EP 0384987 B1 | 16/03/1994 |
| | | JP 02-225630 A | 07/09/1990 |
| | | JP 2914674 B2 | 05/07/1999 |
| | | KR 10-1990-0013094 A | 03/09/1990 |
| | | KR 10-1992-0007882 B1 | 18/09/1992 |
| | | US 4996402 A | 26/02/1991 |

Form PCT/ISA/210 (patent family annex) (January 2015)

**EP 3 901 323 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 1785010 A

- KR 1020070067097